## Europäisches Patentamt

## European Patent Office

## Office européen des brevets

(19)

(11) Veröffentlichungsnummer: **0 124 761**
**B1**

# EUROPÄISCHE PATENTSCHRIFT

(12)

(45) Veröffentlichungstag der Patentschrift:
08.04.87

(21) Anmeldenummer: **84103617.1**

(22) Anmeldetag: **02.04.84**

(51) Int. Cl.⁴: **G 01 R 31/28**

(54) **Einrichtung zur Prüfung von elektrische Schaltkreise enthaltenden Prüflingen.**

(30) Priorität: **08.04.83 DE 3312687**

(43) Veröffentlichungstag der Anmeldung:
**14.11.84 Patentblatt 84/46**

(45) Bekanntmachung des Hinweises auf die Patenterteilung:
**08.04.87 Patentblatt 87/15**

(84) Benannte Vertragsstaaten:
**AT CH DE FR GB IT LI**

(56) Entgegenhaltungen:
**DE-A-2 429 836**
**DE-A-3 106 727**
**DE-A-3 218 814**
**GB-A-1 416 786**

(73) Patentinhaber: **Siemens Aktiengesellschaft Berlin und München, Wittelsbacherplatz 2, D-8000 München 2 (DE)**

(72) Erfinder: **Welzhofer, Klaus, Ruffini- Allee 30, D-8032 Gräfelfing (DE)**

EP 0 124 761 B1

## Beschreibung

Die Erfindung bezieht sich auf eine Einrichtung zur Prüfung von elektrische Schaltkreise enthaltenden Prüflingen, bei der zur Bewertung von vom Prüfling an einem Prüflingsausgang abgegebenen Prüflingssignalen eine Bewerterschaltung und zur Belastung des Prüflingsausgangs mit einer festlegbaren Last eine Lastschaltung vorgesehen ist.

Aus der DE-A1-3 218 814 ist eine rechnergesteuerte Prüfeinrichtung bekannt, die pro Prüflingsstift eine Ansteuerschaltung und eine Auswerterschaltung vorsieht. Mit Hilfe eines Schalters wird der Prüflingsstift entweder mit der Ansteuerschaltung oder der Auswerteschaltung verbunden. Die Ansteuer-Auswerte-Schaltungen haben jeweils programmierbare Spannungsquellen.

Wenn solche rechnergesteuerte Prüfeinrichtungen für die vollautomatische Prüfung von SSI-, MSI-, LSI- und VLSI-Bausteinen verwendbar sein sollen, müssen sie entsprechende Eigenschaften aufweisen. Die Ansteuerschaltung muß in der Lage sein, sowohl die entsprechende vom Prüflingsdatenblatt geforderten Signalpegelparameter an einen Prüflingseingang zu senden, wie auch die Signalpegelwechsel des an den Prüfling anzulegenden Prüfsignals mit der geforderten Flankensteilheit durchzuführen. Schließlich muß im Fall eines bidirektionalen Prüflingsanschlusses, z.B. bei einem Tristate-Bustreiber, der Ausgang der Ansteuerschaltung sehr schnell hochohmig abgeschaltet bzw. wieder eingeschaltet werden können.

Ist der Prüflingsanschluß ein Ausgang, so muß dieser entsprechend dem Prüflingsdatenblatt belastet werden können und zudem das abgegebene Prüflingssignal mittels einer geeigneten Bewerterschaltung anhand von programmierbaren Referenzspannungen und Abtasttakten amplitudenmäßig und zeitlich bewertet werden können. Aus diesem Grunde muß in der Auswerteschaltung eine programmierbare Lastschaltung und eine programmierbare Bewerterschaltung vorgesehen sein.

Da mit der Prüfeinrichtung Prüflinge in unterschiedlichen Schaltkreistechniken, z.B. ECL Technik, TTL Technik oder MOS Technik usw. geprüft werden sollen, müssen die Ansteuerschaltungen und Auswerteschaltungen weite Strom- und Spannungsbereiche programmierbar überdecken, um universell einsetzbar zu sein. Zudem werden an derartige Schaltungen hohe Hochfrequenzanforderungen gestellt, um auch dynamische Prüfungen bei hohen Prüfsignalraten vornehmen zu können.

Die der Erfindung zugrundeliegende Aufgabe besteht darin, eine Einrichtung zur Prüfung von elektrische Schaltkreise enthaltenden Prüflingen anzugeben, die die hohen HF Anforderungen erfüllt und deren Platzbedarf auf einem Baustein trotzdem klein ist. Diese Aufgabe wird bei einer Einrichtung der eingangs angegebenen Art dadurch gelöst, daß der Eingang der Lastschaltung und der Eingang der Bewerterschaltung mit einer zu einer Anschlußklemme führenden Leitung verbunden ist, daß an der Anschlußklemme der Prüflingsausgang anschließbar ist, daß in der Lastschaltung mindestens eine im Stromwert einstellbare, abschaltbare Konstantstromquelle vorgesehen ist, durch die der Prüfling strommäßig belastbar ist, und daß in der Bewerterschaltung mindestens ein Komparator enthalten ist, der zu einer festlegbaren Zeit das Prüflingssignal mit einer einstellbaren Referenzspannung vergleicht.

Es ist vorteilhaft, wenn in der Lastschaltung zwei Konstantstromquellen vorgesehen sind, von denen die eine als Laststromsenke, die andere als Laststromquelle dient, wobei jede Konstantstromquelle getrennt jeweils im Stromwert einstellbar ist und jeweils abschaltbar ist. Damit ist es möglich, den Prüfling mit verschiedenen Strömen, die in entgegengesetzter Richtung fließen können, zu belasten.

Die Verbindung der Konstantstromquellen mit der zur Anschlußklemme führenden Leitung kann über eine Diodenbrücke erfolgen, bei der zwei gegenüberliegende Verbindungspunkte mit den Konstantstromquellen, der dritte Verbindungspunkt mit einer einstellbaren Spannungsquelle und der diagonal gegenüberliegende Verbindungspunkt mit der Leitung zur Anschlußklemme verbunden ist. Mit Hilfe der einstellbaren Spannungsquelle kann dann festgelegt werden, ob die Lastschaltung als Laststromsenke oder Laststromquelle arbeitet, wobei der Wert der einstellbaren Spannungsquelle auch so gewählt werden kann, daß in Abhängigkeit der Amplitude des Prüflingssignals die Lastschaltung zunächst als Laststromquelle bzw. Laststromsenke und anschließend als Laststromsenke bzw. Laststromquelle wirkt.

Vorteilhaft ist es, in der Bewerterschaltung zwei Komparatoren vorzusehen, die über einen Impedanz und Signalpegelkonverter mit der Leitung zur Anschlußklemme verbunden sind. Den Komparatoren werden dann verschiedene, einstellbare Referenzspannungen zugeführt, so daß mehrere Spannungsbereiche gebildet werden können, um festzustellen, in welchen der Spannungsbereiche das Prüflingsausgangssignal fällt. Damit ist es möglich, auch Tristate-Lagen des Prüflingsausgangssignals zu erkennen. Durch den Impedanz- und Spannungspegelkonverter wird erreicht, daß der Eingangswiderstand der Bewerterschaltung sehr hochohmig ist und damit der Prüflingsausgang durch die Bewerterschaltung wenig belastet wird. Weiterhin kann damit das Prüflingssignal an die für die Komparatoren zugelassenen Spannungswerte angepaßt werden.

Andere Weiterbildungen ergeben sich aus den Unteransprüchen.

Anhand eines Ausführungsbeispiels, das in den Figuren dargestellt ist, wird die Erfindung weiter erläutert. Es zeigen

Fig. 1 ein Blockschaltbild der Einrichtung in Zusammenschaltung mit einer Signalgeberschaltung,

Fig. 2 die schaltungstechnische Ausführung der Einrichtung.

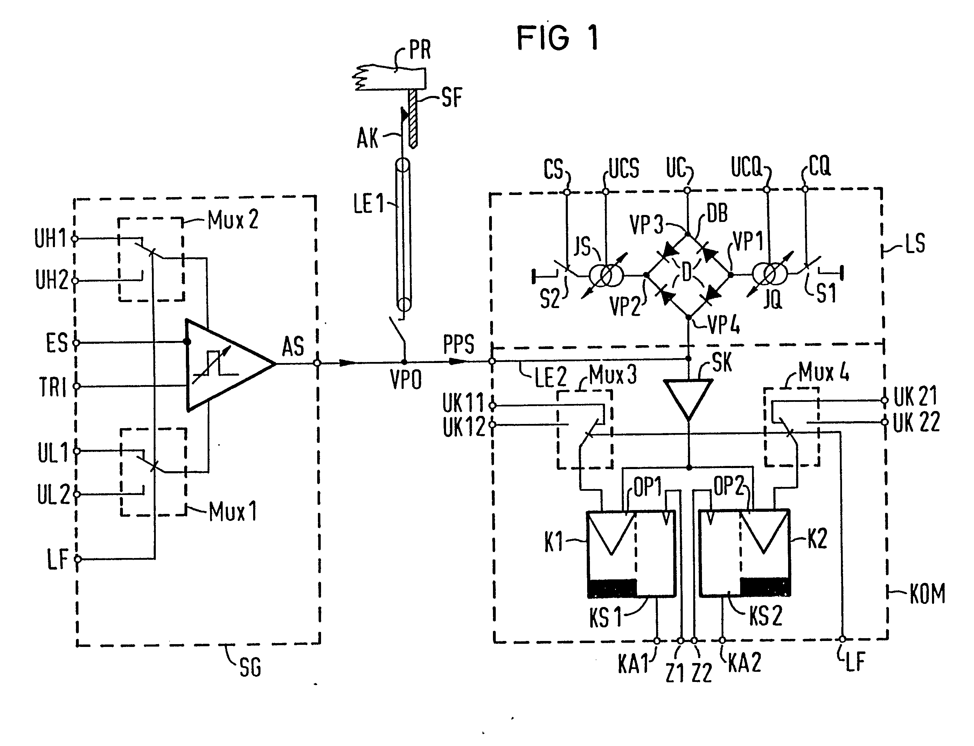

In Fig. 1 ist eine Signalgeberschaltung SG zur Erzeugung von impulsförmigen Ausgangssignalen oder Prüfsignalen, eine Lastschaltung LS und eine Bewerterschaltung KOM dargestellt. Der Ausgang der Signalgeberschaltung SG, der Eingang der Bewerterschaltung KOM und der Eingang der Lastschaltung LS sind miteinander in einem Verbindungspunkt VPO verbunden. Vom Verbindungspunkt VPO führt eine Leitung LE1 zu einer Anschlußklemme AK, die in Verbindung z.B. mit einem Anschlußstift SF eines Prüflings PR steht. Ein solcher Zusammenschluß einer Signalgeberschaltung SG , einer Lastschaltung LS und einer Bewerterschaltung KOM ist dann zweckmäßig, wenn nicht vorher festgelegt werden soll, ob an die Anschlußklemme AK ein Prüflingsausgang oder ein Prüflingseingang angeschlossen werden soll. Dann muß der Ausgang der Signalgeberschaltung SG derart ausgeführt sein, daß bei einem Betrieb, in dem ein Prüflingsausgang angeschlossen ist, durch die Prüflingssignale die Signalgeberschaltung SG nicht zerstört werden kann. Die Lastschaltung LS und die Bewerterschaltung KOM muß dann so realisiert sein, daß bei der Betriebsart, bei der ein Prüflingseingang angeschlossen ist, die Lastschaltung LS und die Bewerterschaltung KOM den Betrieb nicht stören.

In Fig. 1 ist der Aufbau der Signalgeberschaltung SG nur prinzipiell dargestellt. Es ist zu sehen, daß der Signalgeberschaltung ein Eingangssignal ES, z.B. ein TTL Signal zugeführt wird, und daß außerdem über einen ersten Multiplexer MUX1 Steuerspannungen UL1 bzw. UL2 und über einen zweiten Multiplexer MUX2 Steuerspannungen UH1 bzw. UH2 zugeführt werden. Mit Hilfe eines Multiplexersignals LF können die Multiplexer MUXI und MUX2 umgeschaltet werden. Die Steuerspannungen UH1, UH2, UL1, UL2 können z.B. zwischen -15 Volt und +15 Volt variiert werden. Mit Hilfe der Steuerspannungen UH und UL können somit die Amplitudenspannung und die Grundlinienspannung des von der Signalgeberschaltung SG abgegebenen Ausgangssignals AS in weiten Bereichen eingestellt werden. Schließlich kann der Signalgeberschaltung ein Sperrsignal TRI zugeführt werden, bei dessen Anliegen der Ausgang der Signalgeberschaltung SG hochohmig geschaltet wird.

Mit dem Verbindungspunkt VPO ist, wie Fig. 1 zeigt, die Bewerterschaltung KOM über eine Leitung LE2 verbunden. Nach dem Blockschaltbild der Fig. 1 besteht die Bewerterschaltung KOM aus einem Impedanz-und Spannungspegelkonverter SK und zwei Komparatoren K1 und K2. Der Konverter SK ist zwischen die Leitung LE2 und die einen Eingänge der Komparatoren K1 und K2 geschaltet. Die anderen Eingänge der Komparatoren K1 und K2 sind jeweils über Multiplexer MUX3 und MUX4 mit einstellbaren Referenzspannungsquellen verbunden, die Referenzspannungen UK11, UK12 bzw. UK21, UK22 abgeben. Die Referenzspannungen können dabei jeweils zwischen -3 Volt und +3 Volt liegen. Die Umschaltung der Multiplexer MUX3 und MUX4 kann wiederum über ein Multiplexersignal LF erfolgen.

Diese Ausführung der Bewerterschaltung KOM erlaubt es, daß zwischen zwei Referenzspannungspaaren digital gewählt werden kann. Somit ergeben sich für eine Prüflingspegelbewertung drei Spannungsbewertungszonen, wodurch auch Tristate-Lagen des Prüflingsausgangspegels PPS erkannt werden. Zeitlich ausgelöst wird die Pegelbewertung durch Abtasttakte Z1 und Z2, die jedem Komparator K1 und K2 getrennt zugeführt werden. Jeder Komparator K1, K2 kann dazu aus einem Operationsverstärker OP1 bzw. OP2 und einer bistabilen Kippschaltung KS1 bzw. KS2 bestehen, in die der Ausgangswert der Operationsverstärker OP1 bzw. OP2 bei Anliegen des Abtasttaktes T1 bzw. T2 übernommen wird.

Mit Hilfe des Konverters SK können die Pegel des Prüflingsignales an die für die Komparatoren K1 und K2 zugelassenen Eingangsspannungen umgewandelt werden. Weiterhin hat der Konverter SK einen hochohmigen Eingang, so daß die Bewerterschaltung KOM den Prüflingsausgang kaum belastet.

Die Lastschaltung LS besteht aus einer ersten Konstantstromquelle IQ und einer zweiten Konstantstromquelle IS, die mit einer Diodenbrücke DB verbunden sind. Die Konstantstromquellen IQ, IS liegen an den Verbindungspunkten der Diodenbrücke DB, von denen aus die Dioden D in gleicher Richtung gepolt sind. Diese Verbindungspunkte sind mit VP1 und VP2 bezeichnet. An einem dritten Verbindungspunkt VP3 der Diodenbrücke DB liegt eine einstellbare Steuerspannungsquelle mit einer Steuerspannung UC, die z.B. zwischen +15 und -15 Volt verändert werden kann. Am vierten Verbindungspunkt VP4 ist schließlich die Leitung LE2 angeschlossen, die zur Anschlußklemme AK führt.

Die beiden Konstantstromquellen IQ und IS sind in ihren Stromwerten einstellbar mit Hilfe von Führungsspannungen UCQ und UCS und sie sind jeweils schaltbar, wie es in Fig. 1 durch die Schalter S1, S2 prinzizpiell dargestellt ist. Der Schaltzustand der Schalter S1 bzw. S2 wird durch die Spannungen CQ bzw. CS festgelegt.

Die Lastschaltung LS belastet somit den Prüflingsausgang strommäßig, sie kann dabei entweder als Laststromquelle oder Laststromsenke arbeitet. Dabei sind die von der Lastschaltung LS abgegebenen positiven oder negativen Ströme zwischen ca. 50 µA und 50 mA veränderbar.

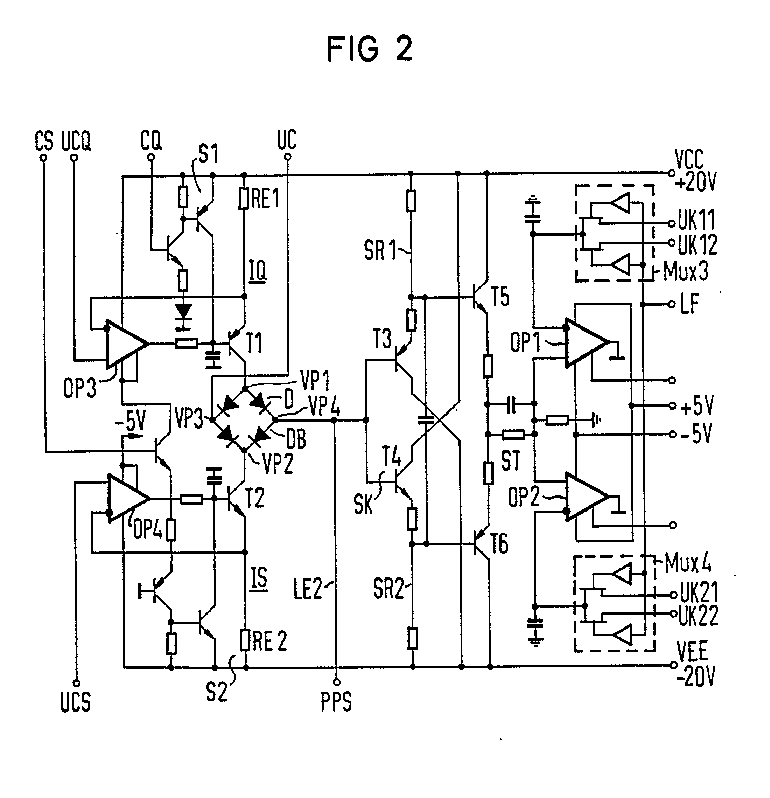

Der genauere Aufbau der Lastschaltung LS ergibt sich aus Fig. 2. Die Konstantstromquelle IQ, besteht aus einem Transistor T1, der über einen Emitterwiderstand RE1 mit einem ersten Betriebspotential VCC verbunden ist und dessen Kollektor an den ersten Verbindungspunkt VP1 der Diodenbrücke DB angeschlossen ist. An der Basis des Transistors T1 liegt der Schalter S1, mit dessen Hilfe der Transistor T1 gesperrt werden kann. Diesem Schalter S1 wird die Steuerspannung CQ zugeführt. Die Einstellung des Stromwertes der Stromquelle erfolgt mit Hilfe eines Operationsverstärkers OP3, dessen einem Eingang die Führungsspannnng UCQ zugeführt wird. Der Ausgang des Operationsverstärkers OP3 ist mit der Basis des Transistors T1 verbunden. Weiterhin besteht eine Rückkopplung zwischen dem Emitter des Transistors T1 und dem invertierenden Eingang des Operationsverstärkers OP3. Durch Veränderung der Führungsspannung UCQ kann der von der Stromquelle IQ in die Diodenbrücke DB gelieferte Konstantstrom verändert werden.

Der Aufbau der zweiten Konstantstromquelle IS entspricht der der ersten Konstantstromquelle IQ, es werden lediglich Transistoren in komplementärer Ausführung verwendet. Die Konstantstromquelle IS enthält einen Transistor T2, der über einen Emitterwiderstand RE2 mit dem Betriebspotential VEE verbunden ist, und dessen Kollektor mit dem Verbindungspunkt VP2 der Diodenbrücke DB verbunden ist. An der Basis des Transistors T2 liegt der zweite Schalter S2, durch den der Transistor T2 gesperrt werden kann. Dem Schalter S2 wird die Steuerspannung CS zugeführt. Die Veränderung des Stromwertes, der von der Konstantstromquelle IS über die Diodenbrücke DB aufgenommen wird, wird mit Hilfe eines Operationsverstärkers OP4 eingestellt, dem die Führungsspannung UCS zugeführt wird und dessen Ausgang mit der Basis des Transistors T2 verbunden ist. Auch hier besteht eine Rückkopplung zwischen dem Emitter des Transistors T2 und dem invertierenden Eingang des Operationsverstärkers OP4. Am dritten Verbindungspunkt VP3 der Diodenbrücke ist die einstellbare Spannungsquelle mit der Spannung UC angeschlossen. Die Spannung UC legt fest, ob die Konstantstromquelle IQ oder die Konstantstromquelle IS den Prüflingsausgang belastet. Die Spannung UC kann so gewählt werden, daß der Konstantstrom der Konstantstromquelle IQ über die Dioden D und den Verbindungspunkt VP4 zur Leitung LE2 fließt oder sie kann so gewählt werden, daß ein Strom über die Leitung LE2, den Verbindungspunkt VP4 und die Dioden D zur Konstantstromquelle IS fließt. Die Spannung UC kann aber auch derart eingestellt werden, daß sich bei änderndem Pegel des Prüflingsausgangsignales zuerst die eine Konstantstromquelle und dann die andere Konstantstromquelle wirksam ist. In diesem Falle erfolgt eine dynamische Umschaltung der Lastschaltung LS in Abhängigkeit des Spannungspegels des Prüflingsausgangssignals PPS.

Die schaltungstechnische Realisierung der Bewerterschaltung KOM ergibt sich ebenfalls aus Fig. 2. Die Leitung LE2, auf der das Prüflingssignal PPS der Bewerterschaltung zugeführt wird, ist mit dem Impedanz- und Spannungspegelkonverter SK verbunden. Dieser besteht aus Transistoren T3, T4, T5, T6 und einem Spannungsteiler ST. Die Transistoren T3, T4, die komplementär ausgeführt sind, sind jeweils mit der Leitung LE2 verbunden. Ihre Kollektoren liegen an dem Betriebspotential VEE bzw. VCC. Ihre Emitter sind über eine Serienschaltung aus jeweils zwei Widerständen mit dem Betriebspotential VCC bzw. VEE verbunden. Der Verbindungspunkt der beiden Widerstände der Serienschaltung SR1 ist mit dem Transistor T5, der Verbindungspunkt der Widerstände der Serienschaltung SR2 mit dem Transistor T6 verbunden. Die Kollektoren der Transistoren T5 bzw. T6 liegen an den Betriebspotential VCC bzw. VEE. Ihre Emitter liegen über einen Widerstand am Spannungsteiler ST.

Der Konverter SK ist derart ausgeführt, daß er einen hohen Eingangswiderstand hat und somit den Prüflingsausgang wenig belastet und daß er andererseits die Spannungspegel des Prüflingsausgangssignals an die Spannungswerte anpaßt, die zum Betrieb der Komparatoren K1 und K2 zugelassen sind. Der Ausgang des Spannungsteilers ST ist jeweils mit dem einen Eingang des Operationsverstärkers OP1 und OP2 verbunden. Am anderen, invertierenden Eingang der Operationsverstärker OP1 bzw. OP2 liegen die Referenzspannungen UK11, UK12 über den Multiplexer MUX3 bzw. die Referenzspannungen UK21, UK22 über den Multiplexer MUX4, wie es in Fig. 1 bereits gezeigt worden ist. Die weitere Ausführung der Bewerterschaltung ist Fig 1 zu entnehmen. Die Komparatoren K1 bzw. K2 geben die Ausgangssignale KA1 bzw. KA2 ab, aus deren Werten sich ergibt, in welchem Spannungsbereich zur Abtastzeit Z1, Z2 der Pegel des Prüflingssignals liegt. Die Signale Z1, Z2 und die Ausgangssignale KA1 und KA2 sowie das Multiplexersignal LF können TTL Pegel haben. Entsprechendes gilt auch für die Spannungen CS, und CQ der Lastschaltung LS.

Wie Fig. 2 zeigt, besteht die Lastschaltung LS und die Bewerterschaltung KOM aus verhältnismäßig wenigen Bauelementen, so daß es leicht möglich ist, die Lastschaltung LS und die Bewerterschaltung KOM auf einem einzigen Funktionsblock in Dickschichttechnologie aufzubauen. Die Signalgeberschaltung SG der Fig. 1 kann in einem getrennten Funktionsblock oder aber auch auf dem Funktionsblock mit der Lastschaltung und der Bewerterschaltung KOM in Dickschichttechnologie realisiert werden. Es ergeben sich damit Funktionsblöcke, die sehr klein sind, so daß jedem Anschlußelement AK der gesamten Prüfeinrichtung ohne großen Platzbedarf ein getrennter Funktionsblock zugeordnet werden kann.

**Patentansprüche**

1. Einrichtung zur Prüfung von elektrische Schaltkreise enthaltenden Prüflingen, bei der zur Bewertung von vom Prüfling (PR) an einem Prüflingsausgang abgegebenen Prüflingssignalen (PPS) eine Bewerterschaltung (KOM) und zur Belastung des Prüflingsausgangs mit einer festlegbaren Last eine Lastschaltung (LS) vorgesehen ist, dadurch gekennzeichnet, daß der Eingang der Lastschaltung (LS) und der Eingang der Bewerterschaltung (KOM) mit einer zu einer Anschlußklemme (AK) führenden Leitung (LE2, LE1) verbunden ist, daß an der Anschlußklemme (AK) der Prüflingsausgang anschließbar ist, daß in der Lastschaltung (LS) mindestens eine im Stromwert einstellbare, abschaltbare Konstantstromquelle (IS; IQ) vorgesehen ist, durch die der Prüfling (PR) strommäßig belastbar ist, und daß in der Bewerterschaltung (KOM) mindestens ein Komparator (K1; K2) enthalten ist, der zu einer festlegbaren Zeit das Prüflingssignal (PPS) mit einer einstellbaren Referenzspannung (UK11, 12; 21, 22) vergleicht.

2. Einrichtung nach Anspruch 1, dadurch gekennzeichnet, daß in der Lastschaltung (LS) zwei Konstantstromquellen (IQ, IS) vorgesehen sind, von denen die eine als Laststromquelle (IQ), die andere als Laststromsenke (IS) dient und daß die Konstantstromquellen jeweils im Stromwert einstellbar und jeweils abschaltbar sind.

3. Einrichtung nach Anspruch 2, dadurch gekennzeichnet, daß in der Lastschaltung (LS) eine Diodenbrücke (DB) vorgesehen ist, daß die Konstantstromauellen (IQ, IS) an den diagonal liegenden Verbindungspunkten (VP1, VP2) der Diodenbrücke angeschlossen sind, von denen aus die Gleichrichter (D) in gleicher Richtung gepolt sind, daß am dritten Verbindungspunkt (VP3) der Diodenbrücke (DB) eine einstellbare Spannungsquelle (UC) angeschlossen ist und der vierte Verbindungspunkt (VP4) der Diodenbrücke (DB) mit der Leitung (LE2) zur Anschlußklemme (AK) verbunden ist.

4. Einrichtung nach Anspruch 3, dadurch gekennzeichnet, daß jede Konstantstromquelle besteht aus einem Transistor (T1 bzw. T2), dessen Emitter über einen Emitterwiderstand (RE1 bzw. RE2) mit einem Betriebspotential (VCC bzw. VEE), dessen Kollektor mit dem Verbindungspunkt (VP1 bzw. VP2) der Diodenbrücke (DB) und dessen Basis mit dem Ausgang eines Transistorschalters (S1 bzw. S2) zum Sperren des Transistors (T1 bzw. T2) und mit dem Ausgang eines Operationsverstärkers (OP3 bzw. OP4) verbunden ist, an dem eine die Stromstärke der Konstantstromquelle (IQ bzw. IS) festlegende Führungsspannung (UCQ bzw. UCS) anliegt.

5. Einrichtung nach einem der Ansprüche 3 oder 4, dadurch gekennzeichnet, daß mit Hilfe der einstellbaren Spannung (UC) festlegbar ist, ob bei eingeschalteten Konstantstromquellen (IQ, IS) die eine oder die andere Konstantstromquelle den Prüflingsausgang belastet.

6. Einrichtung nach einem der vorhergehenden Ansprüche, gekennzeichnet durch die Bewerterschaltung (KOM) aus mindestens einem Komparator (K1; K2) und einem zwischen der Leitung (LE2) und dem Komparator (K1; K2) angeordneten Impedanz- und Spannungspegelkonverter (SK), der das Prüflingssignal (PPS) in ein dem Komparator (K1; K2) angepaßtes Spannungssignal umwandelt.

7. Einrichtung nach Anspruch 6, dadurch gekennzeichnet, daß die Bewerterschaltung (KOM) zwei mit dem Konverter (SK) verbundene Komparatoren (K1, K2) enthält, an denen verschiedene, einstellbare Referenzspannungen (UK11, UK12, UK21, UK22) anliegen, so daß feststellbar ist, in welchem von drei Spannungsbereichen das Prüflingssignal liegt.

8. Einrichtung nach Anspruch 6 oder 7, gekennzeichnet durch den Pegel- und Impedanzkonverter (SK) aus einem ersten Transistor (T3), dessen Kollektor mit einem ersten Betriebspotential (VEE), dessen Emitter über eine erste Serienschaltung (SR1) von zwei Widerständen mit einem zweiten Betriebspotential (VCC) verbunden ist und an dessen Basis das Prüflingssignal (PPS) anliegt, aus einem zweiten zum ersten Transistor (T3) komplementären Transistor (T4), dessen Kollektor mit dem zweiten Betriebspotential (VCC), dessen Emitter über eine zweite Serienschaltung (SR2) von zwei Widerständen mit dem ersten Betriebspotential (VEE) verbunden ist und an dessen Basis das Prüflingssignal (PPS) anliegt, aus einem dritten Transistor (T5), dessen Basis mit dem Verbindungspunkt der Widerstände der ersten Serienschaltung (SR1), dessen Kollektor mit dem zweiten Betriebspotential (VCC) und dessen Emitter über einen Widerstand mit dem Eingang eines Spannungsteilers (ST) verbunden ist, und aus einem vierten zum dritten Transistor (T5) komplementären Transistor (T6), dessen Basis mit dem Verbindungspunkt der Widerstände der zweiten Serienschaltung (SR2), dessen Kollektor mit dem ersten Betriebspotential (VEE) und dessen Emitter über einen Widerstand mit dem Eingang des Spannungsteilers (ST) verbunden ist.

9. Einrichtung nach Anspruch 8, dadurch gekennzeichnet, daß der Ausgang des Spannungsteilers (ST) mit den Eingängen der als Operationsverstärker (OP1, OP2) ausgeführten Komparatoren (K1, K2) angeschlossen ist, und daß an die anderen invertierende Eingänge der Operationsverstärker (OP1, OP2) über jweils einen Multiplexer (MUX3, MUX4) verschiedene Referenzspannungen (UK11, UK12, UK21, UK22) anlegbar sind.

10. Einrichtung nach einem der vorhergehenden Ansprüche, dadurch gekennzeichnet, daß an die Anschlußklemme (AK) zusätzlich zu der Lastschaltung (LS) und der Bewerterschaltung (KOM) eine Signalgeberschaltung (SG) anschließbar ist, und daß die Lastschaltung (LS), die Bewerterschaltung (KOM) und die Signalgeberschaltung (SG) in Hybridtechnik auf einem Baustein angeordnet sind.

## Revendications

1. Dispositif pour contrôler des spécimens contenant des circuits électriques et dans lequel il est prévu un circuit de pondération (KOM) pour pondérer des signaux (PPS) de spécimen, délivrés par le spécimen (PR) au niveau d'une sortie de ce dernier, et un circuit de charge (LS) servant à charger la sortie du spécimen avec une charge pouvant être déterminée, caractérisé par le fait que l'entrée du circuit de charge (LS) et l'entrée du circuit de pondération (KOM) sont reliées à un conducteur (LE2, LE1) aboutissant à une borne de raccordement (AK), que la sortie du spécimen peut être raccordée à la borne de raccordement (AK), qu'il est prévu dans le circuit de charge (LS), au moins une source de courant constant débranchable (IS ; IQ), dont la valeur du courant est réglable et au moyen de laquelle le spécimen (PR) peut être chargé par un courant, et que le circuit de pondération (KOM) contient au moins un comparateur (K1 ; K2), qui compare, à un instant pouvant être fixé, le signal (PPS) du spécimen à une tension de référence réglable (UK11, 12 ; 21, 22).

2. Dispositif suivant la revendication 1, caractérisé par le fait qu'il est prévu, dans le circuit de charge (LS), deux sources de courant constant (IQ, IS), dont l'une est utilisée en tant que source de courant de charge (IQ) et dont l'autre est utilisée en tant que puits de courant de charge (IS), et que les sources de courant constant peuvent être réglées respectivement du point de vue de la valeur du courant et peuvent être débranchées respectivement.

3. Dispositif suivant la revendication 2, caractérisé par le fait qu'un pont de diodes (DB) est prévu dans le circuit de charge (LS), que les sources de courant constant (IQ, IS) sont raccordées aux points de jonction (VP1, VP2) du pont de diodes, qui sont opposées suivant une diagonale et à partir desquels les redresseurs (D) sont polarisés dans le même sens, qu'une source de tension réglable (UC) est raccordée au troisième point de jonction (VP3) du pont de diodes (DB), et que le quatrième point de jonction (VP4) du pont de diodes (DB) est relié par le conducteur (LED) à la borne de raccordement (AK).

4. Dispositif suivant la revendication 3, caractérisé par le fait que chaque source de courant constant est constituée par un transistor (T1 ou T2), dont l'émetteur est relié par l'intermédiaire d'une résistance d'émetteur (RE1 ou RE2) à un potentiel de service (VCC ou VEE) et dont le collecteur est relié au point de jonction (VP1 ou VP2) du pont de diodes (DB) et dont la base est reliée à la sortie d'un commutateur à transistor (S1 ou S2) pour le blocage du transistor (T1 ou T2) et à la sortie d'un amplificateur opérationnel (OP3 ou OP4), à laquelle est appliquée une tension pilote (UCQ ou UCS) déterminant l'intensité du courant de la source de courant constant (IQ ou IS).

5. Dispositif suivant l'une des revendications 3 ou 4, caractérisé par le fait qu'à l'aide de la tension réglable (UC) on peut déterminer si, dans le cas où les sources de courant constant (IQ, IS) sont branchées, l'une ou l'autre des sources de courant constant charge la sortie du spécimen.

6. Dispositif suivant l'une des revendications précédentes, caractérisé par le fait que le circuit de pondération (KOM) est constitué par au moins un comparateur (K1 ; K2) et par un transformateur (SK) d'impédance et de niveau de tension, branché entre le conducteur (LED) et le comparateur (K1 ; K2) et qui transforme le signal (PPS) du spécimen en un signal de tension adapté au comparateur (K1 ; K2).

7. Dispositif suivant la revendication 6, caractérisé par le fait que le circuit de pondération (KOM) contient deux comparateurs (K1, K2) reliés au transformateur (SK) et auxquels différentes tensions de référence réglables (UK11, UK12, UK21, UK22) sont appliquées, de sorte que l'on peut déterminer celle de trois plages de tensions, dans laquelle le signal du spécimen se situe.

8. Dispositif suivant la revendication 6 ou 7, caractérisé par le fait que le transformateur de niveau et d'impédance (SK) est constitué par un premier transistor (T3), dont le collecteur est relié au premier potentiel de service (VEE) et dont l'émetteur est relié à un second potentiel de service (VCC) par l'intermédiaire d'un premier circuit série (SR1) formé de deux résistances, et à la base duquel le signal (PPS) du spécimen est appliqué, par un second transistor (T4) complémentaire du premier transistor (T3) et dont le collecteur est relié au second potentiel de service (VCC) et dont l'émetteur est relié au premier potentiel de service (VEE) par l'intermédiaire d'un second circuit série (SR2) constitué de deux résistances et à la base duquel est appliqué le signal (PPS) du spécimen, par un troisième transistor (T5) dont la base est reliée au point de jonction des résistances du premier circuit série (SR1) et dont le collecteur est relié au second potentiel de service (VCC) et dont l'émetteur est relié par l'intermédiaire d'une résistance à l'entrée d'un diviseur de tension (ST), et par un quatrième transistor (T6) complémentaire du troisième transistor (T5) et dont la base est reliée au point de jonction des résistances du second circuit série (SR2) et dont le collecteur est relié au premier potentiel de service (VEE) et dont l'émetteur est relié par l'intermédiaire d'une résistance à l'entrée du diviseur de tension (ST).

9. Dispositif suivant la revendication 8, caractérisé par le fait que la sortie du diviseur de tension (ST) est raccordée à l'entrée des comparateurs (K1, K2) réalisés sous la forme d'amplificateurs opérationnels (OP1, OP2), et que différentes tensions de référence (UK11, UK12, UK21, UK22) peuvent être appliquées aux autres entrées inverseuses des amplificateurs opérationnels (OP1, OP2), par l'intermédiaire de multiplexeurs respectifs (MUX3, MUX4).

10. Dispositif suivant l'une des revendications précédentes, caractérisé par le fait qu'un circuit générateur de signaux (SG) peut être raccordé à la borne de raccordement (AK) en plus du circuit de charge (LS) et du circuit de pondération (KOM), et que le circuit de charge (LS), le circuit de pondération (KOM) et le circuit générateur de signaux (SG) sont disposés selon la technique hybride sur un module.

**Claims**

1. A device for testing product samples containing electrical circuits, wherein in order to analyse sample signals (PPS) transmitted by the product sample (PR) there is arranged at a specimen output an analysing circuit (KOM) and a load circuit (LS) for presenting the product sample output with a predetermined load, characterised in that the input of the load circuit (LS) and the input of the analysing circuit (KOM) are connected to a line (LE2, LE1) leading to a terminal (AK), that the product sample output can be connected to the terminal (AK), that in the load circuit (LS) at least one disconnect able constant cur rent source (IS; IQ) is arranged, whose current value is adjustable and by means of which the product sample (PR) can be current loaded, and that the analysing circuit (KOM) comprises at least one comparator (K1; K2) which at a predeterminable time compares the product sample signal (PPS) with an adjustable reference potential (UK11, 12; 21, 22).

2. A device as claimed in Claim 1, characterised in that two constant current sources (IQ, IS) are arranged in the load circuit (LS), one of which serves as a load current source (IQ) and the other as a load current sink (IS), and that the constant current value can be respectively adjusted and the sources can be respectively switched off.

3. A device as claimed in Claim 1, characterised in that a diode bridge (DB) is arranged in the load circuit (LS), that the constant current sources (IQ, IS) are connected to those diagonally opposed connection points (VP1, VP2) of the diode bridge with respect to which the rectifiers (D) are poled in the same direction, that an adjustable voltage source (UC) is connected to the third connection point (VP3) of the diode bridge (DB) and the fourth connection point (VP4) of the diode bridge (DB) is connected via the line (LE2) to the terminal (AK).

4. A device as claimed in Claim 3, characterised in that each constant current source consists of a respective transistor (T1 or T2), whose emitter is connected via an emitter resistor (RE1 or RE2 as the case may be) to a respective operating potential (VCC or VEE), whose collector is connected to the associated connection point (VP1 or VP2) of the diode bridge (DB) and whose base is connected to the output of a respective transistor switch (S1 or S2) in order to block the respective transistor (T1 or T2), and to the output of an operational amplifier (OP3 or OP4 as the case may be), to which is fed a respective guide voltage (UCQ or UCS) determining the current strength of each constant current source (IQ and IS).

5. A device as claimed in one of Claims 3 or 4, characterised in that the adjustable voltage (UC) can be used to determine whether one or the other constant current source loads the product sample output when the constant current sources (IQ, IS) are switched on.

6. A device as claimed in one of the preceding Claims, characterised by the analysing circuit (KOM) consisting of at least one comparator (K1; K2) and an impedance and voltage level converter (SK) arranged between the line (LE2) and the comparator (K1; K2) which converts the product sample signal (PPS) into a signal voltage adapted to the comparator (K1; K2).

7. A device as claimed in Claim 6, characterised in that the analysing circuit (KOM) comprises two comparators (K1, K2) connected to the converter (SK), at which different adjustable reference voltages (UK11, UK12, UK21, UK22) occur, so that it is determinable in which of three voltage ranges the product sample signal is arranged.

8. A device as claimed in Claim 6 or 7, characterised by the level and impedance converter (SK) consisting of a first transistor (T3), whose collector is connected to a first operating potential (VEE), whose emitter is connected to a second operating potential (VCC) by a first series· combination (SR1) of two resistors, and to whose base the product sample signal (PPS) is connected; and of a second transistor (T4) complementary to the first transistor (T3), whose collector is connected to the second operating potential (VCC), whose emitter is connected to the first operating potential (VEE) by a second series combination (SR2) of two resistors and to whose base the product sample signal (PPS) is connected; and of a third transistor (T5) whose base is connected to the junction point of the resistors of the first series combination (SR1), whose collector is connected to the second operating potential (VCC) and whose emitter is connected to the input of a voltage divider (ST) by a resistor; and of a fourth transistor (T6), complementary to the third transistor (T5), whose base is connected to the junction point of the resistors of the second series combination (SR2), whose collector is connected to the first operating potential (VEE), and whose emitter is connected to the input of the voltage divider (ST) by a resistor.

9. A device as claimed in Claim 8, characterised in that the output of the voltage divider (ST) is connected to the inputs of the comparators (K1, K2) which are operational amplifiers (OP1, OP2), and that different reference voltages (UK11, UK12, UK21, UK22) can in each case be connected to the other inverting inputs of the operational amplifiers (OP1, OP2) by means of a multiplexer (MUX3, MUX4).

10. A device as claimed in one of the preceding Claims, characterised in that a signal transmitter circuit (SG) can be connected to the terminal (AK) in addition to the load circuit (LS) and the analysing circuit (KOM), and that the load circuit (LS), the analysing circuit (KOM) and the signal transmitter circuit (SC) are arranged on a module in hybrid technology.

**FIG 1**

FIG 2